# EUROPEAN PATENT APPLICATION

(11) **EP 4 583 167 A1**
(43) Date of publication of application: **09.07.2025**
(21) Application number: 22957383.7
(22) Date of filing: 31.08.2022
(51) Int. Cl.: H01L 29/778, H01L 21/338, H01L 29/812

(54) **SEMICONDUCTOR DEVICE AND PRODUCTION METHOD THEREFOR**

(71) Applicant: Tohoku University, Sendai-shi, Miyagi 980-8577 (JP)
(72) Inventor: MATSUOKA, Takashi, Sendai-shi, Miyagi 980-8577 (JP); SUEMITSU, Tetsuya, Sendai-shi, Miyagi 980-8577 (JP)
(74) Representative: Samson & Partner Patentanwälte mbB
(86) International application number: PCT/JP2022/032734
(87) International publication number: WO 2024/047784

(57) **Abstract**

A first semiconductor layer (102) is formed on a substrate (101) by crystal growth of a first nitride semiconductor in a direction along a c-axis. A second semiconductor layer (103) made of a second nitride semiconductor having a band-gap energy larger than that of the first nitride semiconductor is formed on the first semiconductor layer (102). A polarity inversion layer (104) made of AlN and having a Group-V polar surface on a partial region on the second semiconductor layer (103) is formed.

## Description

### TECHNICAL FIELD

The present invention relates to a semiconductor device and a manufacturing method thereof.

### BACKGROUND ART

A recessed gate structure is used in high electron mobility transistors for reducing parasitic resistance while maintaining a high breakdown voltage. For example, in a barrier layer on which a gate electrode is formed, a source electrode and a drain electrode are formed on the barrier layer via a contact layer or a cap layer, thereby reducing parasitic resistance. Moreover, a groove (recess) is formed on the contact layer or the cap layer at the location where a gate electrode is to be formed, to expose the barrier layer, and then the gate electrode is formed (Non-Patent Document 1).

### CITATION LIST

Non-Patent Document 1: T. Suemitsu et al., "30-nm Two-Step Recess Gate InP-Based InAlAs/InGaAs HEMTs", IEEE Transactions on Electron Devices, vol. 49, no. 10, pp. 1694-1700, 2002.

### SUMMARY OF THE INVENTION

However, when achieving the above-mentioned recess gate structure in a nitride semiconductor, there is no suitable etchant capable of etching a nitride semiconductor layer, and therefore wet etching is considered to be virtually impossible. Meanwhile, when etching a nitride semiconductor layer using dry etching with plasma, the crystal is damaged, and this damage causes degradation of device characteristics, such as gate leakage, reduced breakdown voltage, and generation of interface states. Furthermore, with nitride semiconductors, a selective etching technique, which is essential for ensuring uniformity and reproducibility of the recess gate structure, has not yet been established. Thus, conventionally, there has been a problem in that it is not easy to achieve a recess gate structure using a nitride semiconductor.

The present invention has been made to solve problems such as the above problems and aims to make it easier to achieve a recess gate structure using a nitride semiconductor.

A semiconductor device in accordance with the present invention comprises: a substrate; a first semiconductor layer formed on the substrate and made of a first nitride semiconductor epitaxially grown in a positive direction along the c-axis; a second semiconductor layer which is formed on the first semiconductor layer, and which is made of a second nitride semiconductor having a band-gap energy larger than that of the first nitride semiconductor and epitaxially grown in the positive direction along the c-axis, and which forms a heterojunction with the first semiconductor layer;
a polarity inversion layer formed in a partial region on the second semiconductor layer, the polarity inversion layer being made of AlN and having Group-V polarity; a third semiconductor layer which is made of a third nitride semiconductor having of n-type, and which is formed on the second semiconductor layer including the region where the polarity inversion layer is formed; a source electrode and a drain electrode formed on the third semiconductor layer across the region where the polarity inversion layer is formed interposed between the source electrode and the drain electrode; a groove formed through the third semiconductor layer in the region where the polarity inversion layer is formed; and a gate electrode formed on the second semiconductor layer in the region where the groove is formed.

In a configuration example of the semiconductor device, the polarity inversion layer is a layer made by nitriding aluminum oxide.

In a configuration example of the semiconductor device, the third nitride semiconductor is the same as the second nitride semiconductor, the semiconductor device further comprises a fourth semiconductor layer which is formed on the third semiconductor layer, and which is made of a fourth nitride semiconductor having a band-gap energy smaller than that of the third nitride semiconductor and being n-type, the groove is formed through the fourth semiconductor layer and the third semiconductor layer, and the source electrode and the drain electrode are formed on and in contact with the fourth semiconductor layer.

A method for manufacturing a semiconductor device in accordance with the present invention comprises: a first step of forming a first semiconductor layer on a substrate by crystal growth of a first nitride semiconductor in a positive direction along the c-axis; a second step of forming a second semiconductor layer which forms a heterojunction with the first semiconductor layer on and in contact with the first semiconductor layer by crystal growth of a second nitride semiconductor having a band-gap energy larger than that of the first nitride semiconductor in the positive direction along the c-axis; a third step of forming a polarity inversion layer made of AlN and having Group-V polarity in a partial region on the second semiconductor layer; a fourth step of forming a third semiconductor layer on the second semiconductor layer including the region where the polarity inversion layer is formed by crystal growth of a third nitride semiconductor of n-type; a fifth step of forming a source electrode and a drain electrode on the third semiconductor layer across the region where the polarity inversion layer is formed interposed between the source electrode and the drain electrode; a sixth step of forming a groove formed through the third semiconductor layer on the third semiconductor layer in the region where the polarity inversion layer is formed; and a seventh step of forming a gate electrode on the second semiconductor layer in the region where the groove is formed in the third semiconductor layer.

In a configuration example of the method for manufacturing a semiconductor device, the polarity inversion layer is a layer formed by nitriding aluminum oxide formed by oxidizing a surface of the second semiconductor layer.

In a configuration example of the method for manufacturing a semiconductor device, the third nitride semiconductor is the same as the second nitride semiconductor, the fourth step includes forming a fourth semiconductor layer on the third semiconductor layer by crystal growth of a fourth nitride semiconductor having a band-gap energy smaller than the third nitride semiconductor and being n-type, the fifth step includes forming the groove formed through the fourth semiconductor layer and the third semiconductor layer, and the seventh step includes forming the source electrode and the drain electrode on and in contact with the fourth semiconductor layer.

### ADVANTAGEOUS EFFECT OF THE INVENTION

As described above, in accordance with the present invention, a polarity inversion layer which is made of AlN and has Group-V polarity is formed in a partial region on a second semiconductor layer constituted by a nitride semiconductor, and a third semiconductor layer is formed thereon, and therefore a recess gate structure using a nitride semiconductor can be achieved more easily.

### BRIEF DESCRIPTION OF THE DRAWINGS

FIG. 1A shows a cross-sectional view illustrating a state of the semiconductor device in a halfway step for explaining the method for manufacturing the semiconductor device according to an embodiment of the present invention.
FIG. 1B shows a cross-sectional view illustrating a state of the semiconductor device in a halfway step for explaining the method for manufacturing the semiconductor device according to the embodiment of the present invention.
FIG. 1C shows a cross-sectional view illustrating a state of the semiconductor device in a halfway step for explaining the method for manufacturing the semiconductor device according to the embodiment of the present invention.
FIG. 1D shows a cross-sectional view illustrating a state of the semiconductor device in a halfway step for explaining the method for manufacturing the semiconductor device according to the embodiment of the present invention.
FIG. 1E shows a cross-sectional view illustrating a state of the semiconductor device in a halfway step for explaining the method for manufacturing the semiconductor device according to the embodiment of the present invention.
FIG. 1F shows a cross-sectional view illustrating a state of the semiconductor device in a halfway step for explaining the method for manufacturing the semiconductor device according to the embodiment of the present invention.
FIG. 1G shows a cross-sectional view illustrating a state of the semiconductor device in a halfway step for explaining the method for manufacturing the semiconductor device according to the embodiment of the present invention.
FIG. 1H shows a cross-sectional view illustrating a state of the semiconductor device in a halfway step for explaining the method for manufacturing the semiconductor device according to the embodiment of the present invention.
FIG. 1I shows a cross-sectional view illustrating a state of the semiconductor device in a halfway step for explaining the method for manufacturing the semiconductor device according to the embodiment of the present invention.
FIG. 1J shows a cross-sectional view illustrating a state of the semiconductor device in a halfway step for explaining the method for manufacturing the semiconductor device according to the embodiment of the present invention.
   FIG. 1K shows a cross-sectional view illustrating a state of the semiconductor device in a halfway step for explaining the method for manufacturing the semiconductor device according to the embodiment of the present invention.
FIG. 1L shows a cross-sectional view illustrating a state of the semiconductor device in a halfway step for explaining the method for manufacturing the semiconductor device according to the embodiment of the present invention.
FIG. 2 shows a band diagram illustrating the change in conduction band energy in the thickness direction in each layer from a fourth semiconductor layer 106 to a first semiconductor layer 102 in regions where a polarity inversion layer 104 is not formed.

### DETAILED DESCRIPTION OF THE INVENTION

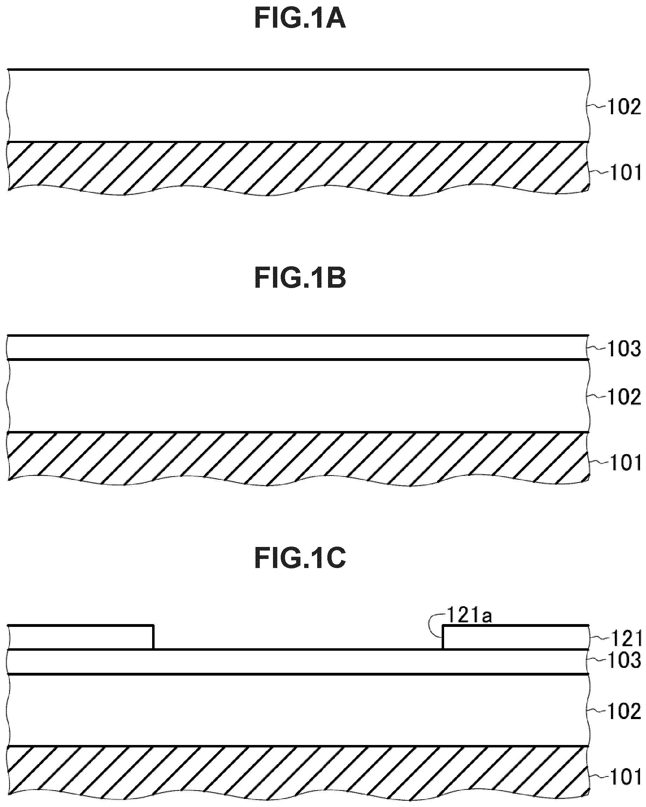

Hereinafter, the method for manufacturing the semiconductor device according to an embodiment of the present invention will be described with reference to FIGS. 1A-1L.

First, as shown in FIG. 1A, a first semiconductor layer 102 is formed on a substrate 101 by crystal growth of a first nitride semiconductor in the positive direction along the c-axis (first step). The substrate 101 may be made of, for example, sapphire. The main surface of the substrate 101 may be the C-plane of sapphire. The first nitride semiconductor may be, for example, GaN. The first nitride semiconductor can be epitaxially grown by a known epitaxial growth technique for nitride semiconductors. In this case, the first nitride semiconductor is epitaxially grown in the positive direction along the c-axis and has Group-III polarity. The first semiconductor layer 102 can be formed to a thickness of, for example, 2 µm. The first semiconductor layer 102 corresponds to a channel layer of a high electron mobility transistor. A nitride semiconductor grown with Group-III polarity in the growth direction is referred to as having Group-III polarity, and a nitride semiconductor grown with Group-V polarity in the growth direction is referred to as having Group-V polarity (N-polarity).

Here, when forming the first semiconductor layer 102 on the substrate 101 made of non-polar sapphire, a buffer layer made of GaN or AlN is first formed on the substrate 101 to a thickness of about 20 to 50 nm. The buffer layer is formed at a low temperature of, for example, 500 to 800 degree centigrade. When crystal-growing the buffer layer, growth conditions are used that result in a crystallinity in which a very small amount of crystalline regions are dispersed in an amorphous material. Next, by heating at high temperature, a crystalline region in the buffer layer is transformed into a growth island by solid phase growth. While heating, the density of the growth island is controlled together with the formation of the growth island. If the density is low, the dislocation density in the single epitaxially grown thereafter at a high temperature is reduced. After the buffer layer is formed in this manner, the first semiconductor layer 102 is subsequently epitaxially grown by high-temperature growth.

Next, as shown in FIG. 1B, a second semiconductor layer 103 is formed on and in contact with the first semiconductor layer 102 (second step). The second semiconductor layer 103 can be constituted by a second nitride semiconductor having a band-gap energy larger than the first nitride semiconductor. The second nitride semiconductor is epitaxially grown in the positive direction along the c-axis to form the second semiconductor layer 103. The second semiconductor layer 103 forms a heterojunction with the first semiconductor layer 102.

The second nitride semiconductor may be, for example, AlGaN. The second nitride semiconductor can be epitaxially grown by a known epitaxial growth technique for nitride semiconductors. In this case, the second nitride semiconductor is epitaxially grown in the positive direction along the c-axis and has Group-III polarity. The second semiconductor layer 103 can be formed to a thickness of, for example, 30 nm. The second semiconductor layer 103 corresponds to (functions as) a barrier layer of a high electron mobility transistor.

In the above-mentioned heterojunction structure between the first semiconductor layer 102 and the second semiconductor layer 103, electrons are accumulated with high concentration in the vicinity of the first semiconductor layer 102 side of the heterojunction interface due to the polarization effect of the nitride semiconductor, forming two-dimensional electron gas. This two-dimensional electron gas takes charge in carrying electrical current of the high electron mobility transistor, that is, it serves as a carrier.

Next, as shown in FIG. 1C, a first mask 121 having a first opening 121a is formed on the second semiconductor layer 103. The first opening 121a is located in a partial region on the second semiconductor layer 103. The first opening 121a is located in a region (region between source and drain) between a region where a source electrode is formed and a region where a drain electrode is formed. For example, the first mask 121 can be formed by depositing an insulating material, such as silicon oxide, on the second semiconductor layer 103 to form an insulating film, and patterning the formed insulating film by known lithography and etching techniques.

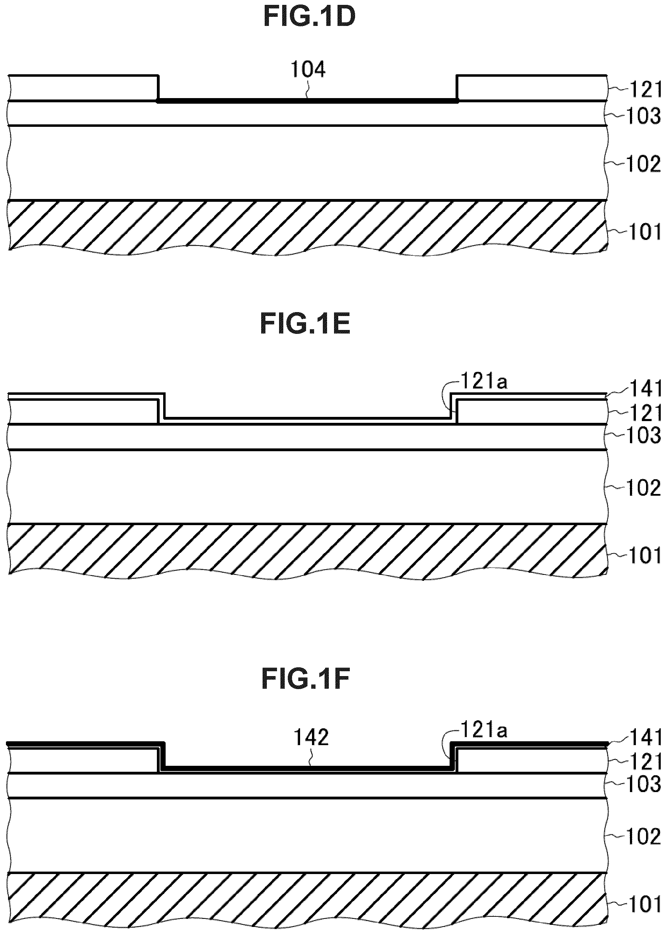

Next, as shown in FIG. 1D, a polarity inversion layer 104 made of AlN and having Group-V polarity is formed on the second semiconductor layer 103 at the location of the first opening 121a on the first mask 121 (third step). The second semiconductor layer 103 has Group-III polarity, and the polarity inversion layer 104 is selectively formed using the first mask 121 to partially form a Group-V polarity region, while the other regions remain Group-III polarity. With respect to the method of forming the polarity inversion layer 104, for example, when the second semiconductor layer 103 is made of a second nitride semiconductor containing Al, first, the surface of the second semiconductor layer 103 exposed on the first opening 121a is oxidized to make the outermost surface of the second semiconductor layer 103 aluminum oxide. By selecting the conditions for the oxidation to select the conditions for this oxidation step, metal atoms other than Al can be evaporated, forming aluminum oxide as a result.

For example, by oxidizing the surface vicinity or the entire second semiconductor layer 103, the surface vicinity or the entire second semiconductor layer 103 is converted to aluminum oxide. As for a method of oxidation treatment, it is possible to use, for example, a method that exposes to an oxygen atmosphere at a high temperature of about 1000°C, a method that exposes to oxygen plasma, and a method that exposes to an oxygen atmosphere under ultraviolet irradiation. Since aluminum oxide is a material that does not have polarity, the aluminum oxide formed here also does not have polarity.

Then, the oxidized second semiconductor layer 103 is exposed to ammonia at a high temperature of, for example, about 1000°C to nitride the surface vicinity or the entire second semiconductor layer 103, and convert the surface vicinity or the entire second semiconductor layer 103 to AlN. The AlN formed by nitriding the aluminum oxide has Group-V polarity. As a result, the polarity inversion layer 104 can be formed.

When the second semiconductor layer 103 is made of a second nitride semiconductor that does not contain Al, the polarity inversion layer 104 can be formed as follows.

First, as shown in FIG. 1E, in a state where the first mask 121 having the first opening 121a is formed, AlN is grown to form an AlN layer 141. The AlN layer 141 has Group-III polarity.

Next, the surface vicinity or the entire AlN layer 141 is oxidized to convert it to aluminum oxide, and an aluminum oxide layer 142 is formed as shown in FIG. 1F. The oxidation treatment may be carried out by, for example, a method that exposes to an oxygen atmosphere at a high temperature of about 1000°C, a method that exposes to oxygen plasma, or a method that exposes to an oxygen atmosphere under ultraviolet irradiation. Since aluminum oxide is a material that does not have polarity, the aluminum oxide layer 142 formed here also has no polarity.

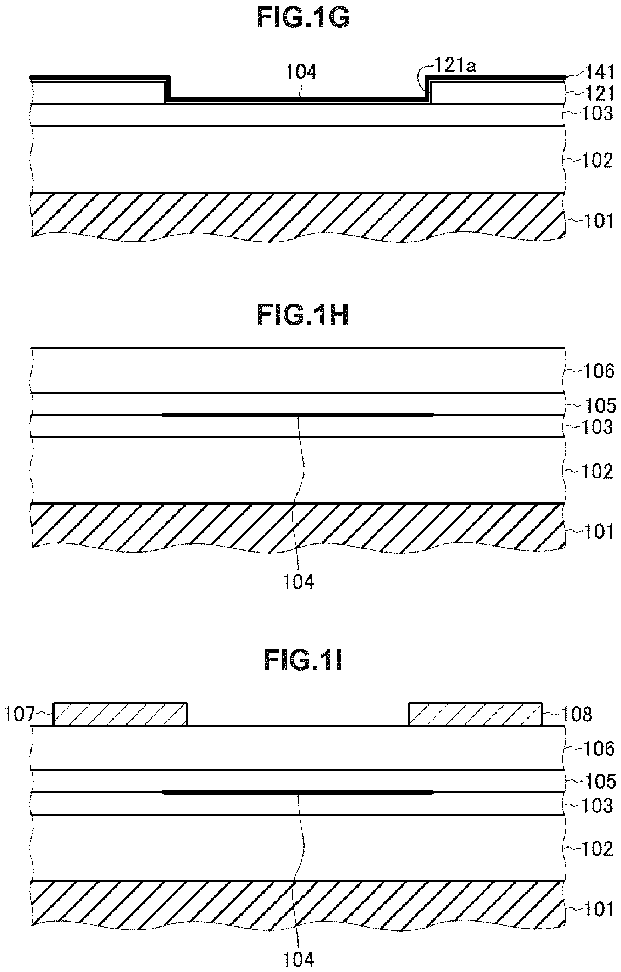

Next, the aluminum oxide layer 142 formed by oxidation is exposed to ammonia at a high temperature of about 1000°C, for example, to nitride the surface vicinity or the entire aluminum oxide layer 142, and convert the surface vicinity or the entire aluminum oxide layer 142 into AlN. The AlN formed by nitriding the aluminum oxide has Group-V polarity. As a result, the polarity inversion layer 104 can be formed as shown in FIG. 1G.

Next, after removing the first mask 121, the third semiconductor layer 105 is formed by crystal growth of an n-type third nitride semiconductor on the second semiconductor layer 103 including a region where the polarity inversion layer 104 is formed, as shown in FIG. 1H (fourth step). Furthermore, a fourth n-type nitride semiconductor is epitaxially grown on the third semiconductor layer 105 to form a fourth semiconductor layer 106. The third n-type nitride semiconductor is epitaxially grown by a known epitaxial growth technique of nitride semiconductors to form the third semiconductor layer 105, and then the fourth n-type nitride semiconductor is epitaxially grown to form the fourth semiconductor layer 106.

For example, the third nitride semiconductor can be a second nitride semiconductor of n-type. For example, the third nitride semiconductor can be made of AlGaN (n⁺-AlGaN) of n-type by doping Si to a high concentration (up to 10¹⁹ cm⁻³). The fourth nitride semiconductor has a band-gap energy smaller than the third nitride semiconductor and is of n-type. For example, the fourth nitride semiconductor can be made of GaN (n⁺-GaN) of n-type by doping with a high concentration of Si (up to 10¹⁹ cm⁻³).

Table 1 below shows examples of the aforementioned first nitride semiconductor, second nitride semiconductor, third nitride semiconductor, and fourth nitride semiconductor, as well as materials.

**Table 1**

| combination of nitride semiconductors | 1 | 2 | 3 | 4 | 5 | 6 | 7 | 8 |
|---|---|---|---|---|---|---|---|---|
| fourth nitride semiconductor | GaN | GaN | GaN | InGaN | InGaN | GaN | GaN | InGaN |
| third nitride semiconductor | AlGaN | InAlN | AlN | AlGaN | InAlN | Al_{y}Ga_{1-y}N (y > x) | AlN | GaN |
| second nitride semiconductor | AlGaN | InAlN | AlN | AlGaN | InAlN | Al_{y}Ga_{1-y}N (y > x) | AlN | GaN |
| first nitride semiconductor | GaN | GaN | GaN | InGaN | InGaN | AlₓGa₁₋ₓN (x: about 0 to 0.2) | AlₓGa₁₋ₓN (x: about 0 to 0.2) | InGaN |

Here, the third semiconductor layer 105 and the fourth semiconductor layer 106 formed as crystals on the second semiconductor layer 103 including a region where the polarity inversion layer 104 is formed grow with N polarity in the region where the polarity inversion layer 104 is formed. Meanwhile, the region where the polarity inversion layer 104 on the second semiconductor layer 103 is not formed has Group-III polarity, and therefore the crystal grows with Group-III polarity on the second semiconductor layer 103 where the polarity inversion layer 104 is not formed. Therefore, the third semiconductor layer 105 and the fourth semiconductor layer 106 in the region where the polarity inversion layer 104 is formed are constituted by N-polar crystals.

Next, as shown in FIG. 1I, a source electrode 107 and a drain electrode 108 are formed on the third semiconductor layer 105 across the region where the polarity inversion layer 104 is formed interposed between the source electrode 107 and the drain electrode 108 (fifth step). In this example, since the fourth semiconductor layer 106 is formed, the source electrode 107 and the drain electrode 108 are formed on the fourth semiconductor layer 106. For example, a lift-off mask (not shown) having an opening in each electrode-forming region is formed, and Ti/Al/Ni/Au is deposited thereon by a sputtering or evaporation technique. The lift-off mask is then removed (lifted off) to form the source electrode 107 and the drain electrode 108. In this example, the source electrode 107 and the drain electrode 108 are formed on the fourth semiconductor layer 106 in contact with the fourth semiconductor layer 106.

Here, the source electrode 107 and the drain electrode 108 do not include a polarity inversion layer 104 but include a region where the third semiconductor layer 105 and the fourth semiconductor layer 106 are grown with Group-III polarity. In this region, as described later, the n-type third semiconductor layer 105 promotes tunneling of electrons between the fourth semiconductor layer 106 and the second semiconductor layer 103, and therefore ohmic contact can be achieved without thermal treatment.

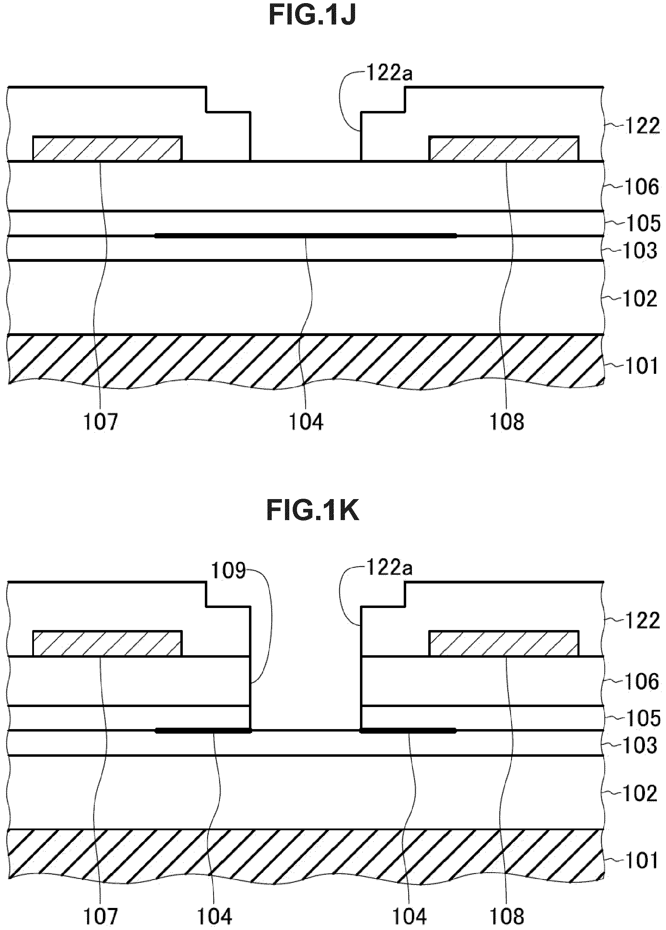

Next, as shown in FIG. 1J, a second mask 122 having a second opening 122a in a region where the polarity inversion layer 104 is formed is formed on the fourth semiconductor layer 106. For example, the second mask 122 can be formed by applying a photosensitive material to the fourth semiconductor layer 106 to form a coating film, and patterning the formed coating film by a known lithography technique.

Next, the fourth semiconductor layer 106 and the third semiconductor layer 105 are etched by wet etching using the second mask 122 thus formed, and a groove 109 formed through the fourth semiconductor layer 106 and the third semiconductor layer 105 is formed as shown in FIG. 1K (sixth step). The groove 109 is formed penetrating the third semiconductor layer 105 and the fourth semiconductor layer 106 in the region where the polarity inversion layer 104 is formed.

For example, the fourth semiconductor layer 106 and the third semiconductor layer 105 in the region on the second opening 122a of the second mask 122 are etched off by wet etching using tetramethylammonium hydroxide (TMAH) as an etching solution. In wet etching with TMAH, the nitride semiconductor having Group-III polarity is hardly etched. Meanwhile, the nitride semiconductor having N polarity can be easily etched off by wet etching with TMAH.

As described above, the fourth semiconductor layer 106 and the third semiconductor layer 105 in the region on the second opening 122a are formed on the polarity inversion layer 104 and have N polarity. Therefore, the groove 109 is easily formed by wet etching with TMAH. As is well known, the nitride semiconductor having Group-III polarity is hardly etched by wet etching. Therefore, in forming the groove 109 by wet etching with TMAH as described above, the etching becomes selective etching that automatically stops at the second semiconductor layer 103 with Group-III polarity. This etching also removes the polarity inversion layer 104 made of AlN, but if aluminum oxide remains below the polarity inversion layer 104, the aluminum oxide is not etched off.

Conventionally, when a recess gate structure is realized in a nitride semiconductor, dry etching is used to form the groove (recess). This causes processing damage to the device, degrading the device characteristics. Furthermore, since the depth of the groove cannot be accurately determined in the groove formation process, the threshold voltage of the HEMT is not as designed. Meanwhile, the selective etching as described above does not cause processing damage to the device, and by stopping the etching at the second semiconductor layer 103, the depth of the groove 109 can be accurately controlled, thereby preventing variations in the threshold voltage among the transistors.

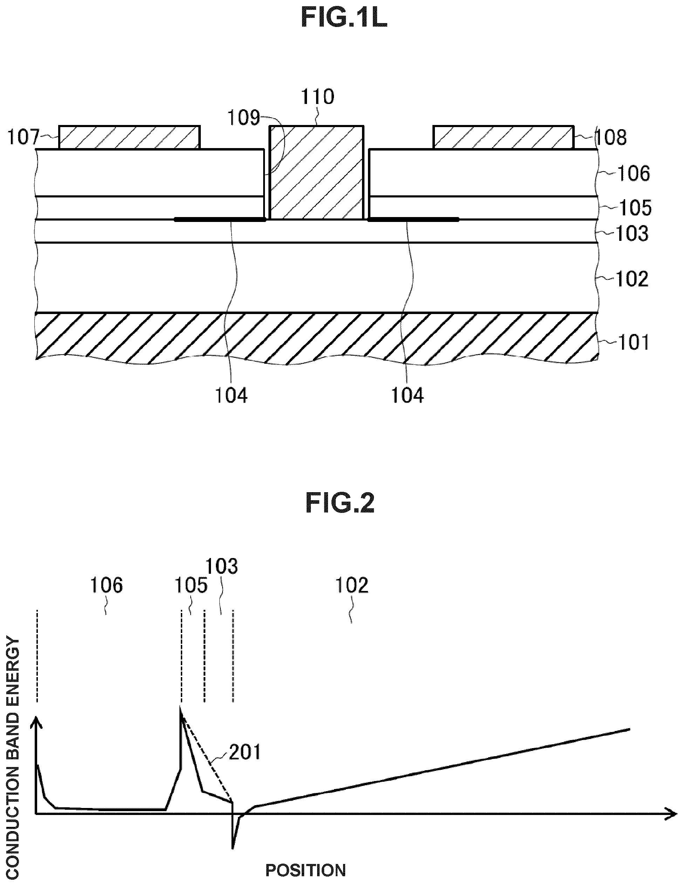

Next, after removing the second mask 122, a gate electrode 110 is formed on the second semiconductor layer 103 in the region where the groove 109 of the third semiconductor layer 105 is formed, as shown in FIG. 1L (seventh step). For example, a lift-off mask (not shown) having an opening in the gate electrode-forming region is formed, and Ni/Au is deposited thereon by a sputtering or evaporation technique. The lift-off mask is then removed (lifted off) to form on the second semiconductor layer 103 a gate electrode 110 as a Schottky contact.

The semiconductor device formed as described above is a well-known high electron mobility transistor, and comprises: a substrate 101; a first semiconductor layer 102 which is made of a first nitride semiconductor epitaxially grown and which is formed on the substrate 101 in the positive direction along the c-axis; a second semiconductor layer 103 which is made of a second nitride semiconductor having a band-gap energy larger than that of the first nitride semiconductor and epitaxially grown in the positive direction along the c-axis, and which is formed on the first semiconductor layer 102, forming a heterojunction with the first semiconductor layer 102; a polarity inversion layer 104 formed in a partial region on the second semiconductor layer103, the polarity inversion layer 104 being made of AlN and having Group-V polarity; a third semiconductor layer 105 which is made of an n-type third nitride semiconductor and which is formed in a region on the second semiconductor layer 103 including a region where the polarity inversion layer 104 is formed; a source electrode 107 and a drain electrode 108 formed on the third semiconductor layer 105, with the polarity inversion layer 104 interposed between the source electrode 107 and the drain electrode 108; a groove 109 formed in a region in the third semiconductor layer 105 where the polarity inversion layer 104 is formed, penetrating the third semiconductor layer 105 (and the fourth semiconductor layer 106); and a gate electrode 110 formed on the second semiconductor layer 103 in a region where the groove 109 is formed.

In this semiconductor device, the polarity inversion layer 104 is a layer made by nitriding aluminum oxide. The third nitride semiconductor may be the second nitride semiconductor, and the semiconductor device may further comprise a fourth semiconductor layer 106 which is formed on the third semiconductor layer 105 and which is constituted by a fourth semiconductor layer 106 of n-type having a band-gap energy smaller than the third nitride semiconductor. In this case, the groove 109 is formed to penetrate the fourth semiconductor layer 106 and the third semiconductor layer 105, and the source electrode 107 and the drain electrode 108 are formed on and in contact with the fourth semiconductor layer 106.

Next, the achievement of low contact resistance between the source electrode 107 and the drain electrode 108 by using the third semiconductor layer 105 and the fourth semiconductor layer 106 will be described now. FIG. 2 shows the change in the conduction band edge (conduction band energy) in each of the layers from the fourth semiconductor layer 106 to the first semiconductor layer 102 in the thickness direction in a region where the polarity inversion layer 104 is not formed. In FIG. 2, the reference numeral 201 indicates the case where the third semiconductor layer 105 is non-doped.

The fourth semiconductor layer 106 in the region where the polarity inversion layer 104 is not formed has Group-III polarity, and the Schottky barrier between the source electrode 107 and the drain electrode 108 can be made low. In addition, the third semiconductor layer 105 in the region where the polarity inversion layer 104 is not formed is made of the same nitride semiconductor as the second semiconductor layer 103, and is made n-type by doping with a high concentration of impurities, and therefore electrons tunnel through the second semiconductor layer 103 to promote the movement from the fourth semiconductor layer 106 to the first semiconductor layer 102, thereby reducing the resistance from the fourth semiconductor layer 106 to the first semiconductor layer 102.

In addition, by providing the third semiconductor layer 105 and the fourth semiconductor layer 106 doped with a high concentration of impurities, even if the surface state changes slightly in the regions between the source electrode 107 and the gate electrode 110 and between the gate electrode 110 and the drain electrode 108, the carrier concentration in the first semiconductor layer 102 is not affected, and long-term stabilization of the source-drain resistance is ensured.

As described above, in accordance with the present invention, a Group-V-polar AlN is formed as a polarity inversion layer in a partial region on the second semiconductor layer, and a third semiconductor layer is formed thereon, and therefore a recess gate structure using a nitride semiconductor can be achieved more easily.

It should be noted that the present invention is not limited to the above-described embodiment, and it is apparent that many modifications and combinations can be implemented by a person skilled in the art within the technical concept of the present invention.

### REFERENCE SIGNS LIST

101: substrate
102: first semiconductor layer
103: second semiconductor layer
104: polarity inversion layer
105: third semiconductor layer
106: fourth semiconductor layer
107: source electrode
108: drain electrode
109: groove
110: gate electrode
121: first mask
121a: first opening
122: second mask
122a: second opening

## Claims

1. A method for manufacturing a semiconductor device, comprising:
a first step of forming a first semiconductor layer on a substrate by crystal growth of a first nitride semiconductor in a positive direction along the c-axis;
a second step of forming a second semiconductor layer which forms a heterojunction with the first semiconductor layer on and in contact with the first semiconductor layer by crystal growth of a second nitride semiconductor having a band-gap energy larger than that of the first nitride semiconductor in the positive direction along the c-axis;
a third step of forming a polarity inversion layer made of AlN and having Group-V polarity in a partial region on the second semiconductor layer;
a fourth step of forming a third semiconductor layer on the second semiconductor layer including the region where the polarity inversion layer is formed by crystal growth of a third nitride semiconductor of n-type;
a fifth step of forming a source electrode and a drain electrode on the third semiconductor layer across the region where the polarity inversion layer is formed interposed between the source electrode and the drain electrode;
a sixth step of forming a groove formed through the third semiconductor layer on the third semiconductor layer in the region where the polarity inversion layer is formed; and
a seventh step of forming a gate electrode on the second semiconductor layer in the region where the groove is formed.

2. The method according to claim 1, wherein
the polarity inversion layer is a layer formed by nitriding aluminum oxide formed by oxidizing a surface of the second semiconductor layer.

3. The method according to claim 1 or 2, wherein
the third nitride semiconductor is the same as the second nitride semiconductor,
the fourth step further includes a step of forming a fourth semiconductor layer on the third semiconductor layer by crystal growth of a fourth nitride semiconductor having a band-gap energy smaller than the third nitride semiconductor and being n-type,
the fifth step includes forming the groove formed through the fourth semiconductor layer and the third semiconductor layer, and
the seventh step includes forming the source electrode and the drain electrode on and in contact with the fourth semiconductor layer.

4. A semiconductor device, comprising:
a substrate;
a first semiconductor layer formed on the substrate and made of a first nitride semiconductor epitaxially grown in a positive direction along the c-axis;
a second semiconductor layer which is formed on the first semiconductor layer, and which is made of a second nitride semiconductor having a band-gap energy larger than that of the first nitride semiconductor and epitaxially grown in the positive direction along the c-axis, and which forms a heterojunction with the first semiconductor layer;
a polarity inversion layer formed in a partial region on the second semiconductor layer, the polarity inversion layer being made of AlN and having Group-V polarity;
a third semiconductor layer which is made of a third nitride semiconductor having of n-type, and which is formed on the second semiconductor layer including the region where the polarity inversion layer is formed;
a source electrode and a drain electrode formed on the third semiconductor layer across the region where the polarity inversion layer is formed interposed between the source electrode and the drain electrode;
a groove formed through the third semiconductor layer in the region of the third semiconductor layer where the polarity inversion layer is formed; and
a gate electrode formed on the second semiconductor layer in the region where the groove is formed in the third semiconductor layer.

5. The semiconductor device according to claim 4, wherein
the polarity inversion layer is a layer made by nitriding aluminum oxide.

6. The semiconductor device according to claim 4 or 5, wherein
the third nitride semiconductor is the same as the second nitride semiconductor,
the semiconductor device further comprises a fourth semiconductor layer which is formed on the third semiconductor layer, and which is made of a fourth nitride semiconductor having a band-gap energy smaller than that of the third nitride semiconductor and being n-type,
the groove is formed through the fourth semiconductor layer and the third semiconductor layer, and
the source electrode and the drain electrode are formed on and in contact with the fourth semiconductor layer.
